# EUROPÄISCHE PATENTANMELDUNG

(11) **EP 4 847 148 A1**
(43) Veröffentlichungstag der Anmeldung: **02.12.2026**
(21) Anmeldenummer: 26163864.7
(22) Anmeldetag: 11.03.2026
(51) Int. Cl.: B05C 11/10, B05C 5/02

(54) **DOSIERVORRICHTUNG FÜR HALBLEITER-LACK**

(30) Priorität: 11.03.2025 DE 102025109265
(71) Anmelder: Muffler, Pirmin, 78359 Orsingen-Nenzingen BW (DE)
(72) Erfinder: Muffler, Pirmin, 78359 Orsingen-Nenzingen BW (DE)
(74) Vertreter: Patentanwälte und Rechtsanwalt Weiß, Arat & Partner mbB

(57) **Zusammenfassung**

Die Erfindung betrifft eine Dosiervorrichtung für Halbleiter-Lack (11) mit einem Lack-Speicher (1), wobei der Lack-Speicher (1) mit einem Entgasungs-Zwischenspeicher (2) verbunden ist, wobei der Entgasungs-Zwischenspeicher (2) mit einem Einweg-Auslassventil (3) zu einem Substratbeschichtungs-Auslass (19) verbunden ist, wobei zwischen dem Entgasungs-Zwischenspeicher (2) und dem Einweg-Auslassventil (3) ein Dosier-Gehäuse (5) angeordnet ist, wobei das Dosier-Gehäuse (5) einen Zulauf (6) und einen Ablauf (7) aufweist, wobei in dem Gehäuse (5) ein Komprimierschlauch (8) von dem Zulauf (6) zu dem Ablauf (7) angeordnet ist, wobei in Arbeitslage in dem Komprimierschlauch (8) Halbleiter-Lack vorhanden ist und zwischen dem Komprimierschlauch (8) und Innenwänden des Dosier-Gehäuses (5) ein Komprimierungsmedium (12) angeordnet ist, wobei das Komprimierungsmedium (12) mit einer Spritzenanordnung (13) wirkverbunden ist.

## Beschreibung

### Technisches Gebiet

Die Erfindung betrifft eine Dosiervorrichtung für Halbleiter-Lack nach dem Oberbegriff des Anspruchs 1 und eine Verwendung der Dosiervorrichtung nach Anspruch 10.

### Stand der Technik

Derartige Dosiervorrichtungen für Halbleiter-Lack sind bereits in vielfältiger Form und Ausgestaltung bekannt und gebräuchlich. So wird beispielsweise in der DE 10 2015 223 227 A1 eine Vorrichtung und ein Verfahren zur chemischen Behandlung eines Halbleiter-Substrats offenbart. Dort ist eine Steuereinrichtung derart ausgebildet, dass die Auftragspumpe der ersten Auftragseinrichtung und/oder der Reinigungseinrichtung in Abhängigkeit der ermittelten Transportposition und der ermittelten Transportgeschwindigkeit eingeschaltet und wieder abgeschaltet wird, sodass das Fluid und/oder das Reinigungsfluid exakt auf die Substrat-Oberseite aufgebracht wird.

### Aufgabe der Erfindung

Die Aufgabe der vorliegenden Erfindung ist es, die Nachteile aus dem Stand der Technik zu überwinden. Insbesondere soll eine Dosiervorrichtung zur Verfügung gestellt werden, die den besonderen Erfordernissen von Halbleiter-Lack gerecht wird und ein rückstandsloses Ausbringen ermöglicht und dabei eine schnelle und genaue Dosierung zur Aufbringung des Halbleiter-Lacks zur Verfügung gestellt wird.

### Lösung der Aufgabe

Zur Lösung der Aufgabe führen die Merkmale nach dem Anspruch 1.

Vorteilhafte Ausgestaltungen sind in den Unteransprüchen beschrieben.

Eine erfindungsgemäße Dosiervorrichtung für Halbleiter-Lack dient dem genauen Ausbringen einer vorbestimmten Menge von Halbleiter-Lack auf ein zu beschichtendes Substrat, bzw. Wafer-Substrat.

Dazu ist ein Lack-Speicher vorhanden, in welchem der Halbleiter-Lack der Dosiervorrichtung zur Verfügung gestellt wird und mit dem Verbinden des Lack-Speichers mit einem Entgasungs-Zwischenspeicher wird der Lack-Speicher Teil der Dosiervorrichtung.

Der Entgasungs-Zwischenspeicher dient als Zwischenspeicher für den Halbleiter-Lack. Außerdem wird ein blasenfreies Zuliefern von Halbleiter-Lack zu einem Dosiergehäuse ermöglicht.

Der Lack-Speicher selbst kann ausgetauscht werden, sodass der Zwischenspeicher eine fortwährende Funktion der Dosiervorrichtung ermöglicht, auch wenn zwischenzeitlich der Lack-Speicher geleert ist und ausgetauscht werden muss. Dazu ist der Lack-Speicher mit dem Entgasungs-Zwischenspeicher verbunden.

Zwischen dem Entgasungs-Zwischenspeicher und einem Einweg-Auslassventil ist ein Dosier-Gehäuse angeordnet. Das Einweg-Auslassventil ist mit einem Substratbeschichtungs-Auslass verbunden. Der Substratbeschichtungs-Auslass dient dem Ausbringen des dosierten Halbleiter-Lacks auf das Substrat bzw. Wafer-Substrat.

Das Dosier-Gehäuse ist dabei zwischen dem Entgasungs-Zwischenspeicher mit dem Einweg-Auslassventil angeordnet.

Das Dosier-Gehäuse weist einen Zulauf und einen Ablauf auf. Der Zulauf ist über das Einweg-Auslassventil mit dem Entgasungs-Zwischenspeicher verbunden, wobei das Einweg-Auslassventil den Halbleiter-Lack nur in eine Richtung, und zwar in Richtung des Dosier-Gehäuses und dabei durch den Zulauf zulässt. Der Ablauf wiederum die
In dem Gehäuse ist ein Komprimierschlauch von dem Zulauf zu dem Ablauf angeordnet. In Arbeitslage ist in dem Komprimierschlauch in definierter Menge Halbleiter-Lack vorhanden, sodass ein Ausbringen einer dosierten Menge Halbleiter-Lack möglich ist.

Dabei ist in Arbeitslage und zwischen dem Komprimierschlauch und Innenwänden des Dosier-Gehäuses ein Komprimierungsmedium angeordnet. Komprimierungsmedium bedeutet, dass es sich um ein gasförmiges oder flüssiges Medium handelt. Dabei ist wichtig, dass wenn ein Druck auf das Komprimierungsmedium ausgeübt wird, der Druck vom Komprimierungsmedium an den Komprimierschlauch weitergegeben wird und durch die Stauchung des Komprimierschlauchs der Halbleiter-Lack aus dem Komprimierschlauch durch den Ablauf und anschließend durch das Einweg-Auslassventil zum Substratbeschichtungs-Auslass geschickt.

Zwischen dem Komprimierungsmedium und einer Spritzenanordnung ist eine Wirkverbindung vorhanden. Wirkverbindung bedeutet in diesem Zusammenhang, dass der Druck auf das Komprimierungsmedium durch die Spritzenanordnung erzeugt wird. Dazu bildet die Spritzenanordnung einen gemeinsamen Prozessraum mit dem Komprimierungsmedium aus, welches in dem Gehäuse angeordnet ist.

Um die Funktionalität zu gewährleisten ist zwischen dem Dosier-Gehäuse und dem Entgasungs-Zwischenspeicher ein Einweg-Einlassventil angeordnet ist.

Dadurch ist eine genaue Dosierung beispielsweise mittels einer pumpenden Bewegung der Spritzenanordnung möglich. Bei jeder komprimierenden Pumpbewegung wird dabei eine bestimmte Menge Halbleiter-Lack aus dem Komprimierschlauch durch das Einweg-Auslassventil zu dem Substratbeschichtungsauslass gedrückt. Bei der anschließenden dekomprimierenden Pumpbewegung wird neuer Halbleiter-Lack aus dem Entgasungs-Zwischenspeicher durch das Einweg-Einlassventil in den Komprimierschlauch gezogen.

Die Spritzenanordnung besteht aus einem Zylinder, einer Düse und einem Dicht-Kolben besteht, wobei die Düse in das Dosier-Gehäuse hinein angeordnet ist und der Zylinder in Arbeitslage Komprimierungsmedium aufweist, sodass ein gemeinsamer Prozessraum zwischen dem Zylinder, der Düse und dem Innenraum des Dosier-Gehäuses vorhanden ist.

Der Dicht-Kolben kann mittels eines Antriebs betätigbar sein, um die oben beschriebene dosierte Pumpbewegung zu automatisieren. Dazu kann der Antrieb über eine Rechnersteuerung programmiert ansteuerbar sein.

Weiter kann der Komprimierschlauch in dem Dosier-Gehäuse austauschbar angeordnet sein. Dies ist dann vorteilhaft, wenn es beispielsweise zu Ablagerungen von Halbleiter-Lack an bestimmten Stellen des Komprimierschlauchs kommt. Dann ist ein Austausch vorteilhaft, um Verunreinigungen oder Verstopfungen zu vermeiden. Dazu kann beispielsweise das Dosiergehäuse geöffnet, der Komprimierschlauch gelöst und durch einen neuen Komprimierschlauch ersetzt werden.

In einem besonderen Ausführungsbeispiel ist in dem Dosier-Gehäuse zwischen dem Komprimierschlauch und den Innenwänden des Dosier-Gehäuses eine Folie angeordnet, wobei zwischen dem Komprimierschlauch und der Folie in Arbeitslage ein Vakuum vorhanden ist. In so einem Fall ist der Austausch besonders einfach gestaltet, da die Komprimierungsmedium nicht freigegeben wird, sondern lediglich das Vakuum zwischen der Folie und dem Komprimierschlauch aufgelöst wird. Danach lässt sich der alte Komprimierschlauch einfach entfernen und der neue Komprimierschlauch mit dem Dosiergehäuse verbinden. Wenn anschliessend wieder das Vakuum zwischen der Folie und dem Komprimierschlauch hergestellt ist, kann der Betrieb der Dosiervorrichtung fortgesetzt werden. Als reversible Verbindung zwischen dem Komprimierschlauch und dem Dosier-Gehäuse kommen Schraubverbindungen, Klemmverbindungen oder dergleichen in Betracht.

Bei der genutzten Folie kann es sich beispielsweise um eine Perfluoralkoxy-Polymere- Folie (PFA-Folie) oder eine Polytetrafluorethen-Folie (PTFE-Folie) handeln.

Der Komprimierschlauch besteht bevorzugt aus synthetischem Kautschuck, wie beispielsweise Ethylen-Propylen-Dien-Monomer (EPDM).

Zusätzlich wird die Verwendung der Dosiervorrichtung mit folgenden Schritten beschrieben:
- der Lackspeicher wird mit dem Entgasungs-Zwischenspeicher verbunden;
- der Antrieb betätigt programmiert den Dicht-Kolben, sodass das Komprimierungsmedium in dem Zylinder durch die Düse in das Innere des Dosiergehäuses gedrückt wird;
- gleichzeitig verschließt sich das Einweg-Einlassventil zwischen dem Entgasungs-Zwischenspeicher und dem Dosier-Gehäuse und öffnet sich das Einweg-Auslassventil, sodass der Halbleiter-Lack aus dem Komprimierschlauch zu dem Substratbeschichtungs-Auslass gebracht.

### Figurenbeschreibung

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Figur 1: ist eine erfindungsgemäße Dosiervorrichtung in Dekompressionslage gezeigt;
- Figur 2: ist die erfindungsgemäße Dosiervorrichtung in Kompressionslage gezeigt.

### Ausführungsbeispiel

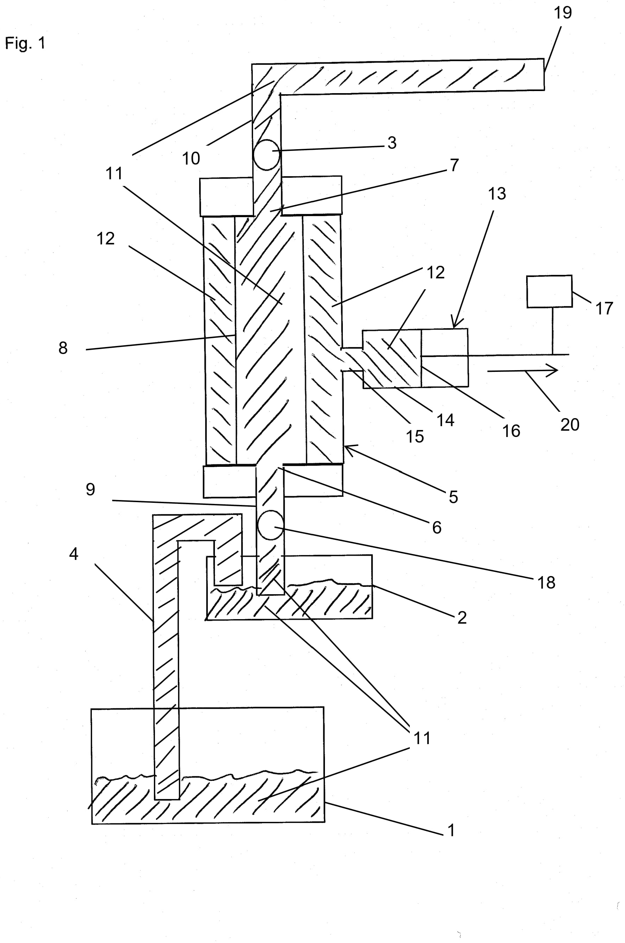

In Figur 1 ist eine erfindungsgemäße Dosiervorrichtung für Halbleiter-Lack 11 gezeigt. Dort ist ein Lackspeicher 1 vorhanden. In diesem Lack-Speicher 1 ist der Halbleiter-Lack 11 aufbewahrt, bevor er zur Aufbringung auf einem Substrat bzw. Wafer-Substrat entnommen und dosiert aufgebracht wird.

Der Lack-Speicher 1 ist über eine Versorgungsleitung 4 mit einem Entgasungs-Zwischenspeicher 2 verbunden. Auch in dem Entgasungs-Zwischenspeicher 2 befindet sich Halbleiter-Lack 11 zur Entgasung und blasenfreien Dosierung.

Der Entgasungs-Zwischenspeicher 2 ist über eine zweite Versorgungsleitung 9 und einem darin angeordneten Einweg-Einlassventil 18 mit einem Dosier-Gehäuse 5 verbunden. Dabei ist das Einweg-Einlassventil 18 zwischen dem Entgasungs-Zwischenspeicher 2 und dem Dosier-Gehäuse 5 angeordnet. Andernends des Dosier-Gehäuses 5 ist in einer dritten Versorgungsleitung 10 ein Einweg-Auslassventil 3 vorhanden. Der aus dem Dosier-Gehäuse 5 gedrückte Halbleiter-Lack 11 läuft durch das Einweg-Auslassventil 2 zu einem Substratbeschichtungs-Auslass 19.

Das Dosier-Gehäuse 5 ist zwischen dem Entgasungs-Zwischenspeicher 2 und dem Einweg-Auslassventil 3 angeordnet. Dabei weist das Dosier-Gehäuse 5 einen Zulauf 6 für die zweite Versorgungsleitung 9 und einen Ablauf 7 für die dritte Versorgungsleitung 10 auf.

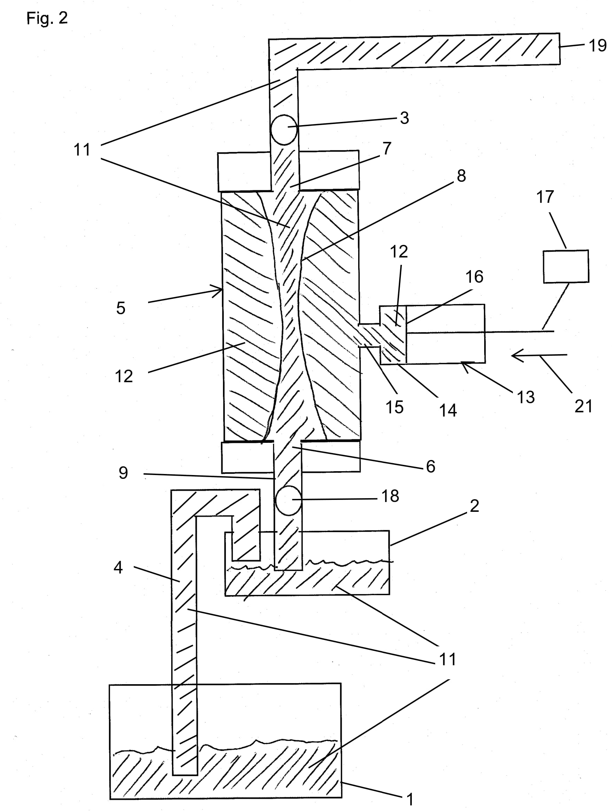

In dem Gehäuse 5 ist ein Komprimierschlauch 8 von dem Zulauf 6 zu dem Ablauf 7 hin angeordnet, wobei in der gezeigten Dekompressionslage der Komprimierschlauch 8 derart gefüllt ist, dass ein Ausbringen durch eine in der Figur 2 gezeigte Kompressionslage bevorsteht. Arbeitslage bedeutet im Rahmen der Erfindung, dass die Dosiervorrichtung zum Einsatz bereit ist. Entgegen der Arbeitslage ist auch eine Austauschlage gegeben. In der Austauschlage, wird der Komprimierschlauch in der unten beschriebenen Weise ausgetauscht.

In Arbeitslage ist in dem Komprimierschlauch 8 also Halbleiter-Lack 11 zum Ausbringen durch den Ablauf 7 und die anschließende dritte Versorgungsleitung 10 bereit.

Zwischen dem Komprimierschlauch 8 und Innenwänden des Dosier-Gehäuses 5 ist ein Komprimierungsmedium 12 angeordnet. Das Komprimierungsmedium 12 ist mit einer Spritzenanordnung 13 wirkverbunden. Wirkverbunden bedeutet hierbei, dass die Spritzenanordnung 13 mit dem Innenbereich des Dosier-gehäuses 5, welcher das Komprimierungsmedium aufnimmt einen gemeinsamen Prozessraum bildet.

Dazu besteht die Spritzenanordnung 13 aus einem Zylinder 14, einer Düse 15 und einem Dicht-Kolben 16, wobei die Düse 15 in das Dosier-Gehäuse 5 hinein angeordnet ist und der Zylinder 14 in Arbeitslage immer Komprimierungsmedium 12 aufweist.

Der gemeinsame Prozessraum ist derart definiert, dass das Komprimiermedium 12 innerhalb des Zylinders 14 und der Düse 15 vorhanden ist und bei Kompression des Inhalts des Zylinders 14 auch das Komprimiermedium 12 innerhalb des Dosier-Gehäuses 5 komprimiert wird.

Der Dicht-Kolben 16 ist mittels eines Antriebs 17 betätigbar. Das bedeutet, dass der Antrieb 17 beispielsweise in der in Figur 1 gezeigte Dekompressionslage den Dicht-Kolben 16 weg von dem Dosier-Gehäuse 5 zieht und damit Druck von der Komprimierflüssigkeit nimmt, sodass Halbleiter-Lack 11 aus dem Entgasungs-Zwischenspeicher 2 in den Komprimierschlauch 8 zieht. Das ist in der Figur 1 durch einen Dekompressionspfeil 20 angedeutet.

Zusätzlich kann vorgesehen werden, dass der Antrieb 17 über eine Rechnersteuerung programmiert ansteuerbar ist.

In der Figur 2 ist eine Kompressionslage gezeigt. Dort ist nun beispielsweise durch den Antrieb 17 der Dicht-Kolben 16 hin zu dem Dosier-Gehäuse 5 geschoben, sodass das Komprimiermedium 12 Druck auf den Komprimierschlauch 8 ausübt und dabei den im Komprimierschlauch 8 vorhandenen Halbleit-Lack 11 in definierter Menge aus dem Komprimierschlauch 8 durch das Einweg-Auslassventil 18 hin zu dem Substratbeschichtungs-Auslass 19 drückt. Die Bewegung des Dicht-Kolbens 16 ist durch einen Kompressionspfeil 21 angedeutet.

Währenddessen verschließt das Einweg-Einlassventil 18, sodass nach der Kompressionslage in dem Komprimierschlauch 8 wiederum ein Unterdruck entsteht und weiterer Halbleiter-Lack 11 aus dem Entgasungs-Zwischenspeicher 2 gezogen wird. Ein Rücklauf des herausgezogenen Halbleiter-Lacks 11 wird durch das Einweg-Einlassventil 18 verhindert. Während des Herausziehens hin zur Dekompressionslage aus der Figur 1 ist das Einweg-Auslassventil 3 verschlossen, damit ein entsprechender Unterdruck im Komprimierschlauch 8 entstehen kann.

Der Komprimierschlauch 8 ist in dem Dosier-Gehäuse 5 austauschbar angeordnet ist. In Austauschlage wird zunächst Das Dosier-Gehäuse 5 geöffnet. In dem Dosier-Gehäuse 5 zwischen dem Komprimierschlauch 8 und den Innenwänden des Dosier-Gehäuses 5 nicht eine nicht näher gezeigte Folie angeordnet, wobei zwischen dem Komprimierschlauch 8 und der Folie in Arbeitslage ein Vakuum vorhanden ist. Dadurch liegt die Folie eng an dem Komprimierschlauch 8 an. Für den Austausch kann durch das Öffnen des Dosier-Gehäuses 5 oder zusätzlich durch Einblasen von Luft das Vakuum zwischen der Folie und dem Komprimierschlauch 8 aufgehoben werden.

Anschließend kann der Komprimierschlauch 8 mit dem restlichen im Komprimierschlauch 8 befindlichen Halbleiter-Lack 11 von dem Dosier-Gehäuse 5 gelöst und entnommen werden. Anschließend kann ein neuer Komprimierschlauch 8 eingesetzt, mit dem Dosier-Gehäuse 5 verbunden, das Dosier-Gehäuse 5 verschlossen, das Vakuum zwischen Folie und Komprimierschlauch 8 wieder hergestellt und dadurch die Arbeitslage wieder eingerichtet werden.

Erfindungsgemäß wird die Dosiervorrichtung durch folgende Hauptschritte verwendet:
- der Lackspeicher 1 wird mit dem Entgasungs-Zwischenspeicher 2 verbunden;
- der Antrieb 17 betätigt programmiert den Dicht-Kolben 16, sodass das Komprimierungsmedium 12 in dem Zylinder 14 durch die Düse 15 in das Innere des Dosier-Gehäuses 5 gedrückt wird;
- gleichzeitig verschließt sich das Einweg-Einlassventil 18 zwischen dem Entgasungs-Zwischenspeicher 2 und dem Dosier-Gehäuse 5 und öffnet sich das Einweg-Auslassventil 3, sodass der Halbleiter-Lack 11 aus dem Komprimierschlauch 8 zu dem Substratbeschichtungs-Auslass 19 gebracht.

### Bezugszeichenliste

| | |
|---|---|
| 1 | Lack-Speicher |
| 2 | Entgasungs-Zwischenspeicher |
| 3 | Einweg-Auslassventil |
| 4 | Versorgungsleitung |
| 5 | Dosier-Gehäuse |
| 6 | Zulauf |
| 7 | Ablauf |
| 8 | Komprimierschlauch |
| 9 | Zweite Versorgungsleitung |
| 10 | Dritte Versorgungsleitung |
| 11 | Halbleiter-Lack |
| 12 | Komprimierungsmedium |
| 13 | Spritzenanordnung |
| 14 | Zylinder |
| 15 | Düse |
| 16 | Dicht-Kolben |
| 17 | Antrieb |
| 18 | Einweg-Einlassventil |
| 19 | Substratbeschichtungs-Auslass |
| 20 | Dekompressionspfeil |
| 21 | Kompressionspfeil |

## Patentansprüche

1. Dosiervorrichtung für Halbleiter-Lack (11) mit einem Lack-Speicher (1), wobei der Lack-Speicher (1) mit einem Entgasungs-Zwischenspeicher (2) verbunden ist, wobei der Entgasungs-Zwischenspeicher (2) mit einem Einweg-Auslassventil (3) zu einem Substratbeschichtungs-Auslass (19) verbunden ist,
**dadurch gekennzeichnet, dass**
zwischen dem Entgasungs-Zwischenspeicher (2) und dem Einweg-Auslassventil (3) ein Dosier-Gehäuse (5) angeordnet ist, wobei das Dosier-Gehäuse (5) einen Zulauf (6) und einen Ablauf (7) aufweist, wobei in dem Gehäuse (5) ein Komprimierschlauch (8) von dem Zulauf (6) zu dem Ablauf (7) angeordnet ist, wobei in Arbeitslage in dem Komprimierschlauch (8) Halbleiter-Lack vorhanden ist und zwischen dem Komprimierschlauch (8) und Innenwänden des Dosier-Gehäuses (5) ein Komprimierungsmedium (12) angeordnet ist, wobei das Komprimierungsmedium (12) mit einer Spritzenanordnung (13) wirkverbunden ist, wobei zwischen dem Dosier-Gehäuse (5) und dem Entgasungs-Zwischenspeicher (2) ein Einweg-Einlassventil (18) angeordnet ist.

2. Dosiervorrichtung nach Anspruch 1, **dadurch gekennzeichnet, dass** die Spritzenanordnung (13) aus einem Zylinder (14), einer Düse (15) und einem Dicht-Kolben (16) besteht, wobei die Düse (15) in das Dosier-Gehäuse (5) hinein angeordnet ist und der Zylinder (14) in Arbeitslage Komprimierungsmedium (12) aufweist.

3. Dosiervorrichtung nach Anspruch 2, **dadurch gekennzeichnet, dass** der Dicht-Kolben (16) mittels eines Antriebs (17) betätigbar ist.

4. Dosiervorrichtung nach Anspruch 3, **dadurch gekennzeichnet, dass** der Antrieb (17) über eine Rechnersteuerung programmiert ansteuerbar ist.

5. Dosiervorrichtung nach einem der Ansprüche 1 bis 4, **dadurch gekennzeichnet, dass** der Komprimierschlauch (8) in dem Dosier-Gehäuse (5) austauschbar angeordnet ist.

6. Dosiervorrichtung nach einem der vorigen Ansprüche, **dadurch gekennzeichnet, dass** der Komprimierschlauch (8) aus synthetischem Kautschuck, wie beispielsweise Ethylen-Propylen-Dien-Monomer (EPDM) besteht.

7. Dosiervorrichtung nach einem der vorigen Ansprüche, **dadurch gekennzeichnet, dass** in dem Dosier-Gehäuse (5) zwischen dem Komprimierschlauch (8) und den Innenwänden des Dosier-Gehäuses (5) eine Folie angeordnet, wobei zwischen dem Komprimierschlauch (8) und der Folie in Arbeitslage ein Vakuum vorhanden ist.

8. Dosiervorrichtung nach Anspruch 7, **dadurch gekennzeichnet, dass** die Folie eine PFA-Folie oder eine PTFE-Folie ist.

9. Verwendung einer Dosiervorrichtung nach einem der Ansprüche 1 bis 8 **gekennzeichnet durch** folgende Schritte:
- der Lackspeicher (1) wird mit dem Entgasungs-Zwischenspeicher (2) verbunden;
- der Antrieb (17) betätigt programmiert den Dicht-Kolben (16), sodass das Komprimierungsmedium (12) in dem Zylinder (14) durch die Düse (15) in das Innere des Dosiergehäuses (5) gedrückt wird;
- gleichzeitig verschließt sich das Einweg-Einlassventil (18) zwischen dem Entgasungs-Zwischenspeicher (2) und dem Dosier-Gehäuse (5) und öffnet sich das Einweg-Auslassventil (3), sodass der Halbleiter-Lack (11) aus dem Komprimierschlauch (8) zu dem Substratbeschichtungs-Auslass (19) gebracht.
